(19) Europäisches Patentamt
European Patent Office
Office européen des brevets

(11) **EP 1 219 921 B1**

(12) **EUROPÄISCHE PATENTSCHRIFT**

(45) Veröffentlichungstag und Bekanntmachung des Hinweises auf die Patenterteilung:
**27.10.2010   Patentblatt 2010/43**

(51) Int Cl.:
***G01B 11/02*** *(2006.01)*   ***H04N 13/00*** *(2006.01)*
***H01L 27/146*** *(2006.01)*   ***G01B 11/24*** *(2006.01)*

(21) Anmeldenummer: **01130552.1**

(22) Anmeldetag: **21.12.2001**

(54) **Verfahren zur Bestimmung der Abweichung des Pixelortes der Pixel mindestens einer Bildaufnahmematrix von der Sollposition**

Procedure to determine the deviation of the desired pixel position of the pixels of at least one image matrix

Procédé pour déterminer la déviation de la position désirée des pixels d'au moins une matrice d'image

(84) Benannte Vertragsstaaten:
**AT BE CH CY DE DK ES FI FR GB GR IE IT LI LU MC NL PT SE TR**

(30) Priorität: **28.12.2000   DE 10065120**

(43) Veröffentlichungstag der Anmeldung:
**03.07.2002   Patentblatt 2002/27**

(73) Patentinhaber: **INB Vision AG**
**39120 Magdeburg (DE)**

(72) Erfinder: **Lilienblum, Tilo, Dr.**
**39104 Magdeburg (DE)**

(74) Vertreter: **Leinung, Günter et al**
**Schuster, Müller & Partner**
**Patentanwälte**
**Olvenstedter Strasse 15**
**39108 Magdeburg (DE)**

(56) Entgegenhaltungen:
**DE-C1- 19 623 172     DE-C1- 19 727 281**

- **TSAI R Y: "A VERSATILE CAMERA CALIBRATION TECHNIQUE FOR HIGH-ACCURACY 3D MACHINE VISION METROLOGY USING OFF-THE-SHELF TV CAMERAS AND LENSES" IEEE JOURNAL OF ROBOTICS AND AUTOMATION, IEEE INC. NEW YORK, US, Bd. RA-3, Nr. 4, August 1987 (1987-08), Seiten 323-344, XP000891213**

**Beschreibung**

Die Erfindung betrifft ein Verfahren zur Bestimmung der Abweichung der Position der Pixel mindestens einer Bildaufnahmematrix von der Sollposition. Das Verfahren ist vorzugsweise verwendbar zur Bestimmung solcher Abweichungen der Position von Pixeln, die bei einer Kalibrierung eines 3D-Messsystems nicht berücksichtigt werden. Aus der Abweichung der Position der Pixel von der Sollposition ist bei bekannter Sollposition die absolute Position der Pixel bestimmbar.

Unter "Bildaufnahmematrix" soll eine Anordnung verstanden werden, die eine flächenhaft verteilte Lichtintensität aufnehmen und als Matrix ausgeben kann. Beispiele sind der CCD-Sensor und der ebenfalls in Kameras eingesetzte CMOS-Sensor. Die einzelnen Elemente der Matrix werden als Pixel bezeichnet.

Für die "Position eines Pixels" wird abkürzend die Bezeichnung "Pixelort" verwendet, wobei die "Position eines Pixels" durch die Position des Mittelpunkts des Pixels repräsentiert wird.

Bei einer idealen Bildaufnahmematrix sind die Pixelorte in einem idealen Raster mit konstanter Rasterweite angeordnet. Die Pixelorte einer solchen idealen Bildaufnahmematrix sind ideale Pixelorte; ihre Position wird als "Sollposition" bezeichnet.

Zur Berücksichtigung von Abweichungen des realen Pixelrasters vom idealen Pixelraster ist es bekannt, ein Referenzmaß zu vermessen. Beispielsweise kann der Abstand zweier Punkte dadurch vermessen werden, dass die Mittelpunkte beider Punkte bestimmt werden. Zur Bestimmung jedes Mittelpunktes fließen mehrere Pixel mit ein. So mittelt sich ein eventueller Fehler heraus. Den durchschnittlichen Abstand der Pixel kann man so mit großer Genauigkeit bestimmen, da der Gesamtfehler bei der Bestimmung der Mittelpunkte gleich bleibt und der relative Fehler bei entsprechender Pixelanzahl kleiner wird.

Solche Fehler werden normalerweise bei einer Kalibrierung eines 3D-Messsystems [Luhmann, T.: Nahbereichsphotogrammetrie. Wichmann Verlag, Heidelberg] mit berücksichtigt. Abweichungen einzelner Pixelorte vom idealen Pixelraster werden so aber nicht erfasst.

Das von einem bestimmten Pixel erzeugte Signal lässt sich folgendermaßen bestimmen:

$$u = \int\limits_A MTF(x, y) \cdot \Phi(x, y)\, dx\, dy$$

Dabei bezeichnet *u* das ausgegebene Signal für dieses Pixel. MTF ist die Modulationstransferfunktion in Abhängigkeit von der Lage (x,y) und Φ ist der Lichtstrom/Fläche an der Stelle x,y. Die Integrationsfläche A ist normalerweise größer als die Fläche des Pixels, da von benachbarten Pixeln Elektronen über die Pixelgrenzen diffundieren können.

Bei der mathematischen Weiterverarbeitung der Signale der Pixel wird normalerweise angenommen, dass die Intensitätsverteilung einem Dirac-Impuls im Mittelpunkt des Pixels entspricht.

Eine Abweichung der Position der Pixel einer Bildaufnahmematrix von der Sollposition, d. h. ein Fehler im Pixelort, kann durch mehrere Ursachen bedingt sein, von denen nachfolgend zwei genannt sind.

1. Durch eine Abweichung der Geometrie der lichtempfindlichen Fläche von der Sollposition verschiebt sich auch der Mittelpunkt des Pixels.
2. Durch Ungleichmäßigkeiten in der Lichtempfindlichkeit kann es dazu kommen, dass die MTF unsymmetrisch *und/oder nicht orts-invariant* ist. Der Schwerpunkt der Lichtempfindlichkeit würde dadurch ebenfalls verschoben werden. Diese Schwerpunktabweichung hat einen ähnlichen Effekt wie eine Abweichung der Geometrie. Die Ungleichmäßigkeit der Lichtempfindlichkeit kann z. B. durch eine Abweichung der Quanteneffizienz hervorgerufen werden.

Die Fertigung von Bildaufnahmematrizen (z. B. CCD-Sensor) ist offensichtlich so genau, dass ein Fehler im Pixelort bei den meisten derzeitigen Anwendungen keine wesentliche Rolle spielt. Auf Lageungenauigkeiten der Pixel wird in der Literatur nur selten eingegangen. So findet man in [Theuwissen, A. J. P.: Solid State Imaging with Charge-Coupled Devices. Kluwer Academic Publishers] den Hinweis, dass Ungleichmäßigkeiten in der Geometrie, Dicke der Layer, Dotierungsgrad oder Dotierungsprofil existieren und zu Ungleichmäßigkeiten der Pixel führen.

Diese Ungleichmäßigkeiten werden normalerweise mit den Größen PSFU (photo response Non Uniformity, Photoempfindlichkeitsungleichförmigkeit) und DSNU (Dark Signal Non Uniformity, Dunkelsignalungleichförmigkeit) erfasst (Siehe z. B. [Ratledge, D.: The art and science of CCD astronomy. Springer Verlag 1997]). Die Korrektur von PSFU und DSNU kann als Stand der Technik bezeichnet werden. In einigen Kameras ist solch eine Korrektur auch standardmäßig integriert.

Es sind auch Verfahren bekannt, bei denen eine Information über die reale Position der Pixel einer Bildaufnahmematrix wichtig ist. Dies betrifft z. B. Verfahren zur optischen 3D-Vermessung mit Kameras. Hier können auch kleine Abweichungen des Pixelortes zu relevanten Fehlern in den berechneten 3D-Daten führen. Ein spezielles Verfahren, bei dem durch Fehler in den Pixelorten Fehler in den berechneten 3D-Daten hervorgerufen werden, ist das Verfahren nach DE 19623172 C1.

Eine Möglichkeit, die realen Pixelorte zu bestimmen, ist das Scannen der Bildaufnahmematrix mit einem Laser. Für jeden Punkt der vom Laser angefahren wird, kann bestimmt werden, wie an dieser Stelle die Lichtempfindlichkeit ist und zu welchem Pixel dieser Punkt gehört. Auf diese Weise kann für jedes Pixel die MTF bestimmt werden.

Für viele Anwender der optischen 3D-Vermessung mit Kameras ist jedoch der Aufwand für eine Anlage zum Scannen der Bildaufnahmematrix mit einem Laser indiskutabel groß.

Dokument DE 19 727 281 offenbart ein Verfahren zur geometrischen Kalibrierung von CCD-Kameras mittels einer kohärenten Lichtquelle und eines syntetischen Hologramms.

Der Erfindung liegt daher die Aufgabe zugrunde, ein mit vertretbarem Aufwand einsetzbares Verfahren anzugeben, mit dem die realen Pixelorte einer Bildaufnahmematrix bzw. die Abweichungen zwischen den realen Pixelorten und den idealen Pixelorten bestimmt werden kann, ohne dass der Einsatz eines Laserscanners erforderlich ist.

Diese Aufgabe wird mit Merkmalen des Anspruchs 1 gelöst.

Gemäß der Erfindung hängt es von der mit dem Verfahren zu erzielenden Genauigkeit ab, wie oft die im Anspruch 1 angegebenen Teilschritte a) bis e) wiederholt werden müssen. Dabei ist hervorzuheben, dass es nicht zwingend notwendig ist, dass bei jeder Wiederholung eine Verschiebung zwischen Objekt und Messsystem erfolgt. Im Rahmen der Erfindung ist es möglich, beispielsweise nur nach jeder 3-ten oder allgemeiner nach jeder n-ten Wiederholung eine Verschiebung zwischen Objekt und Messsystem durchzuführen.

Vorteilhafte Weiterbildungen sowie Hinweise zur zweckmäßigen Ausführung der Erfindung ergeben sich aus den Unteransprüchen und dem Ausführungsbeispiel.

In den Ansprüchen und dem folgenden Text werden Messpunkte auf der Oberfläche des im erfindungsgemäßen Verfahren eingesetzten Objektes als "3D-Messpunkte" und deren Koordinaten als "3D-Daten" bezeichnet.

Durch die Kenntnis des Fehlers des Pixelortes kann

- der reale Pixelort bestimmt werden. Dadurch können bei Verfahren, die z. B. zur vollen Ausschöpfung ihrer Genauigkeit auf den realen Pixelort angewiesen sind, die korrekten Werte verwendet werden.
- bei Verfahren, die von einem idealen Pixelort ausgehen, eine solche Erweiterung erfolgen, dass Fehler der Pixelorte mit berücksichtigt werden, wodurch z. B. der Einsatzbereich und/oder die Genauigkeit derartiger Verfahren vergrößert werden kann.

An das Objekt, das im erfindungsgemäßen Verfahren verwendet wird, ist grundsätzlich die Anforderung zu stellen, dass es zur Vermessung mittels eines optischen 3D-Messsystems geeignet ist. Weiterhin ist es erforderlich, dass ein ebenes Objekt oder ein Objekt mit einer solchen Krümmung verwendet wird, dass durch die Glättung der ermittelten 3D-Daten des Objekts nur die lokalen Fehler der 3D-Daten ausgemittelt und nicht die Konturen des Objektes verändert werden. Unter dem lokalen Fehler sollen Fehler wie z. B. die statistische Messunsicherheit verstanden werden. Dieser Fehler grenzt sich insbesondere vom globalen Fehler, also dem Absolutfehler der gemessenen 3D-Koordinaten zum Weltkoordinatensystem ab.

Der Fachmann kann aufgrund dieser Angaben geeignete konkrete Objekte festlegen. Insbesondere ist dem Fachmann bekannt, dass die Oberfläche des verwendeten Objektes keine für das Ergebnis relevante Rauhigkeit besitzen darf.

In einer bevorzugten Ausführungsform der Erfindung erfolgt die Verschiebung zwischen Objekt und 3D-Messsystem vorteilhaft in Richtung der Flächennormale des Objekts, die üblicherweise in Richtung der z-Achse des Messsystems weist. Die Ausrichtung der Flächennormale des Objekts in Richtung der z-Achse des 3D-Messsystems ist jedoch keine notwendige Bedingung für die Anwendung des erfindungsgemäßen Verfahrens.

Im folgenden ist die Erfindung anhand eines Ausführungsbeispiels unter Bezugnahme auf die beigefügten Zeichnungen mit weiteren Einzelheiten näher erläutert. Als optisches 3D-Messverfahren, das im Rahmen des Ausführungsbeispiels stellvertretend für verschiedene bekannte 3D-Messverfahren verwendet wird, wurde das auf die Anmelderin zurückgehende Verfahren nach DE 19623172 ausgewählt.

In den Zeichnungen zeigen

Figur 1: Auswirkungen eines Fehlers des Pixelortes auf die berechneten 3D-Daten,

Figur 2: Auswirkungen eines Fehlers des Pixelortes in zwei Kameras auf die berechneten 3D-Daten,

Figur 3: Verschiebung des ebenen Objektes in Richtung seiner Flächennormale (z-Achse),

Figur 4: Schematischer Ablaufplan der Erfindung

Wenn 3D-Daten von Messpunkten auf einer Objektoberfläche mittels des 3D-Messverfahrens nach DE 19623172 bestimmt werden, sind diese fehlerbehaftet. Eine Fehlerquelle sind die Fehler der Pixelorte.

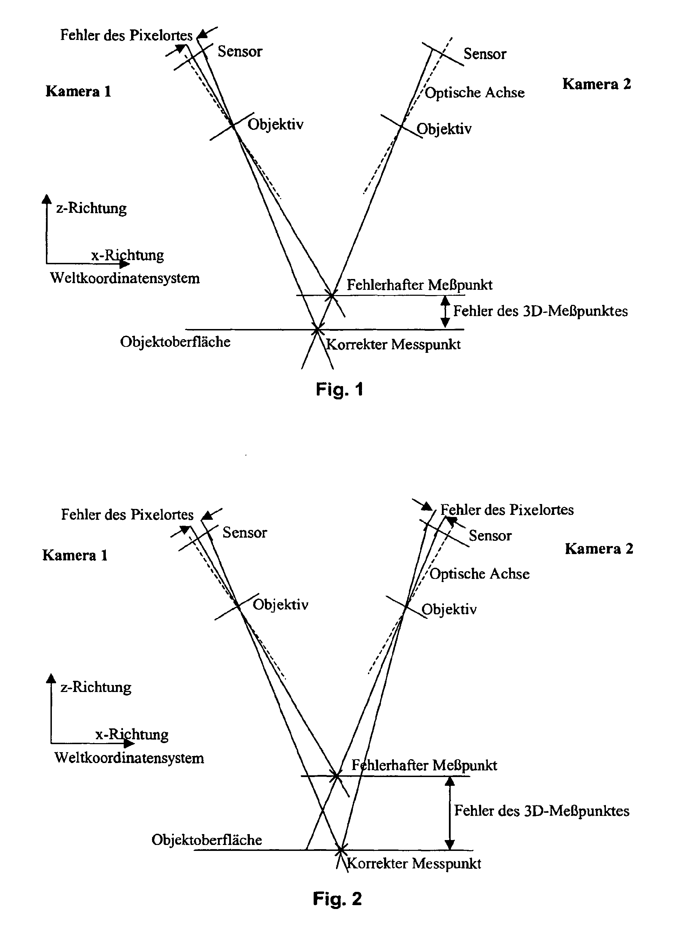

Figur 1 illustriert den Einfluss des Fehlers eines Pixelortes einer Bildaufnahmematrix auf das Messergebnis. Die Ansicht erfolgt aus Richtung der y-Achse auf die xz-Ebene. Das bedeutet, dass nur ein Fehler des Pixelortes in x- bzw. z-Richtung des Weltkoordinatensystems in dieser Abbildung illustriert wird. Analoge Zusammenhänge ergeben sich auch für eine Sicht aus der x-Richtung auf die yz-Ebene.

*Bestimmung des Fehlers der 3D-Daten des 3D-Messpunktes:*

Die Berechnung des Fehlers der 3D-Daten eines vorgebenen Messpunktes erfolgt durch Differenzbildung zwischen den gemessenen, fehlerhaften 3D-Daten und den korrekten 3D-Daten des Messpunktes.

Die korrekten 3D-Daten können auf die im folgenden beschriebene Art bestimmt werden, wenn eine ebene bzw. eine leicht gekrümmte Fläche mit folgenden Eigenschaften vermessen wird:

- Die Fläche sollte keine für das Ergebnis relevante Rauhigkeit besitzen. Eine zu große Rauhigkeit bewirkt ein fehlerhaftes Ergebnis bei der Berechnung des genauen Pixelortes.
- Die Fläche muss keine ideale Ebene sein. Die Krümmung darf aber nicht zu groß sein.

Die aus der Messung resultierenden 3D-Daten werden nun geglättet. Unter Glättung soll verstanden werden:

- Eine Filterung mit einem linearen oder nichtlinearen lokalen Glättungs-Operator. Dazu sollten sich die x- und y-Koordinaten der einzelnen Messpunkte in einem äquidistanten Raster befinden. Die z-Koordinaten können so in einer Matrix angeordnet werden und diese Matrix kann als Bild aufgefasst werden. Die Glättung eines solchen Bildes ist Stand der Technik.
- Eine Approximation der 3D-Daten. Die Approximationsfunktion (z. B. eine Splines-Fläche) muss so beschaffen sein, dass ein ausreichender Glättungseffekt erfolgt.

Da das Messobjekt nicht stark gekrümmt ist (In diesem Fall würde die Glättung die Krümmung verändern.), erhält man durch diese Vorgehensweise korrekte 3D-Daten eines Messpunktes. Durch Differenzbildung kann man nun, wie oben erwähnt, den Fehler ermitteln. Statt von Figur 1 kann auch von den in Figur 2 dargestellten geometrischen Relationen ausgegangen werden, um die korrekten 3D-Daten eines Messpunktes zu berechnen.

*Berechnung des Fehlers des Pixelortes aus dem Messfehler:*

Der Fehler des Pixelortes kann entsprechend Figur 1 aus dem Fehler der 3D-Daten des 3D-Messpunktes zurückgerechnet werden.
Die Projektion eines Punktes vom Weltkoordinatensystem in das Bild erfolgt folgendermaßen:

$$\vec{p_k} = R\left(\vec{p} - \vec{p_l}\right)$$

$$x_{sensor} = \frac{C_x \, p_{kx}}{p_{kz}}$$

$$y_{sensor} = \frac{C_y \, p_{ky}}{p_{kz}}$$

dabei gilt:

$$\vec{p_k} = \begin{bmatrix} p_{kx} \\ p_{ky} \\ p_{kz} \end{bmatrix} = \quad \text{Messpunkt im Kamera-}$$

koordinatensystem (in mm)
$\vec{p}$ = Messpunkt (in mm)

$$\vec{p_l} = \quad \text{Lage des Kamerakoordinatensystems}$$

(in mm)
$R$ = Rotationsmatrix (Lage des Kamerakoordinatensystems
$x_{sensor}$ = x-Position auf dem Sensor (in Pixel)
$y_{sensor}$ = y-Position auf dem Sensor (in Pixel)
$C_x, C_y$ = Brennweite in x- bzw. y-Richtung (in Pixel)

Die x- und die y-Position auf dem Sensor kann nun für die korrekten 3D-Daten und die fehlerhaften 3D-Daten des jeweiligen Messpunktes berechnet werden. Die Differenz zwischen den auf diese Weise ermittelten Sensorpositionen entspricht dem Fehler des Pixelortes an der betreffenden Stelle des Sensors.

*Problem der Uneindeutigkeit:*

Es gibt unterschiedliche Möglichkeiten, aus dem Fehler der 3D-Daten eines Messpunktes den Fehler des Pixelortes zu berechnen. In Figur 1 wird davon ausgegangen, dass der Fehler nur in einem Sensor auftritt. In Figur 2 wird angenommen, dass sich die Fehler der beiden Sensoren ergänzen. Für beide Möglichkeiten gilt, dass die Eindeutigkeit der Berechnung nicht gegeben ist, da nicht bekannt ist, welche Kamera welchen Messfehler hervorruft.

*Lösung des Problems der Uneindeutigkeit der berechneten Fehler:*

Diese Messung wird mehrmals durchgeführt. Nach möglichst jeder Messung wird das Messobjekt in Richtung seiner Flächennormale verschoben, die hier mit der z-Richtung zusammenfällt.

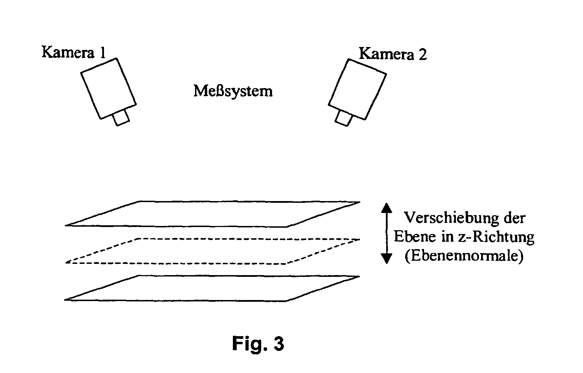

Figur 3 illustriert diese Verfahrensweise. Dadurch werden bei der Rückprojektion des Messpunktes immer andere Pixel der Bildaufnahmematrix miteinander kombiniert.

Ein Fehler des Pixelortes kann nun für jede Einzelmessung auf unterschiedliche Art bestimmt werden, z. B. kann angenommen werden, dass

- nur eine Bildaufnahmematrix den Fehler verursacht. Der Fehler des Pixelortes muss dann zunächst für alle Bildaufnahmematrizen separat berechnet werden.
- beide (bzw. alle) Bildaufnahmematrizen den Fehler verursachen.

Danach wird aus den Ergebnissen aller Messungen ein gemitteltes Ergebnis berechnet. Der berechnete Fehler eines bestimmten Pixelortes einer bestimmten Bildaufnahmematrix resultiert dann aus folgenden Fehlerquellen:

- wirklicher Fehler des betreffenden Pixelortes. Dieser Fehler tritt in allen Messungen gleichermaßen auf und wird durch die Mittelung nicht verringert.
- Fehler des korrespondierenden Pixels auf der anderen Bildaufnahmematrix. Da das korrespondierende Pixel bei jeder Einzelmessung wechselt, würde sich dieser Fehler durch die Mittelung verringern.
- Sonstige Fehlerquellen, z. B. Rauschen. Diese Fehlerquellen würden ebenfalls durch die Mittelung verringert werden.

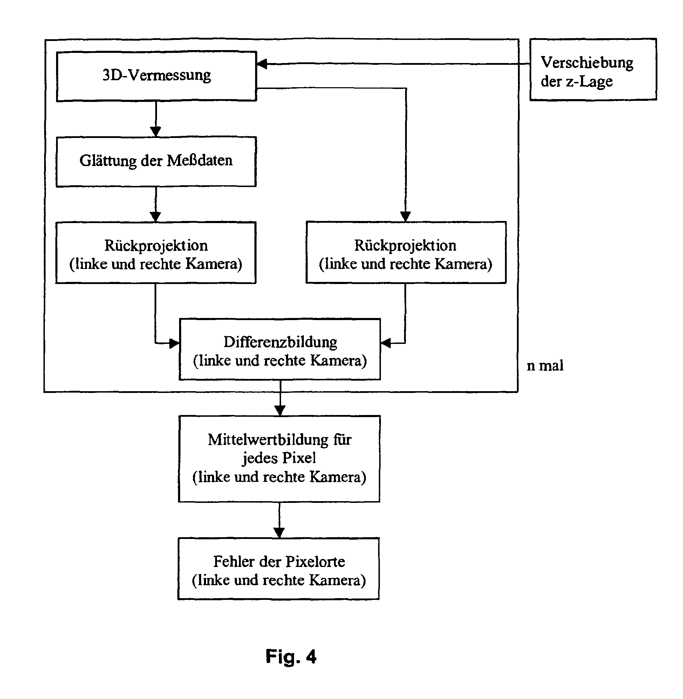

Bei einer Mittelung ausreichend vieler Messungen kann somit für jede Bildaufnahmematrix und für jedes Pixel der Fehler des Pixelortes berechnet werden. Figur 4 illustriert die Vorgehensweise bei einer Berechnung des Fehlers nach Figur 2.

Der Fehler eines bestimmten Pixels einer Kamera tritt immer an der gleichen Stelle auf. Der Einfluss des Fehlers der jeweils anderen Pixel tritt immer an einer anderen Stelle auf (wird immer mit einem anderen Pixel kombiniert) und verschwindet durch die Mittelung.

Die Mittelwertbildung für jedes Pixel kann z. B. erfolgen, indem der Mittelwert aller berechneten Fehler, die einem bestimmten Pixel zugeordnet werden können gebildet wird.

Es ist sinnvoll, wenn die Bestimmung der Messpunkte mit einer höheren Dichte als der Dichte der zugehörigen Pixel erfolgt. Als Ausgangsbasis für die Mittelwertbildung liegt dann eine relativ dichte Punktewolke vor. Dadurch wird das Ergebnis nach der Mittelwertbildung exakter.

Es besteht auch die Möglichkeit, die Punktewolke mit einer Funktion zu approximieren (z. B. durch eine Splineapproximation).

Endergebnis ist eine Matrix, die für jedes Pixel zwei Werte enthält: einen Fehler des Pixelortes in x-Richtung und in y-Richtung.

**Patentansprüche**

1.  Verfahren zur Bestimmung der Abweichung des Pixelortes der Pixel mindestens einer Bildaufnahmematrix von der Sollposition, wobei die Bildaufnahmematrix mindestens während des Verfahrensablaufs Bestandteil eines optischen 3D-Messsystem ist, wobei

a) ein Objekt bereitgestellt wird, das zur Vermessung mittels des optischen 3D-Messsystems geeignet ist, wobei dieses Objekt eben ist oder eine solche Krümmung aufweist, dass bei der durch die Glättung entsprechende Schritt c nur die lokalen Fehler der 3D-Daten ausgemittelt und nicht die Konturen des Objektes verändert werden,

b) das Objekt durch das 3D-Messsystem vermessen wird und dabei 3D-Daten des Objektes ermittelt werden,

c) danach die ermittelten 3D-Daten des Objektes geglättet werden,

d) die 3D-Messpunkte des Objektes unter Verwendung ihrer sowohl nach Schritt b ermittelten als auch nach Schritt c geglätteten 3D-Daten auf die Sensoren der mindestens einen Matrixkamera rückprojiziert werden,

e) die Differenz zwischen der Position der beiden auf die Sensoren rückprojizierten Punkte ermittelt wird, die einem 3D-Messpunkt zugeordnet sind,

f) danach wahlweise eine Verschiebung zwischen Objekt und optischem 3D-Messsystem erfolgt oder unterlassen wird,

g) die Schritte b bis f solange wiederholt werden, bis die gewünschte Genauigkeit der durch das Verfahren zu bestimmenden Abweichungen des Pixelortes der Pixel einer Bildaufnahmematrix erreicht ist, wobei die Genauigkeit von der Anzahl der Wiederholungen und der Anzahl der Verschiebungen entsprechend Schritt f abhängt,

h) und aus den entsprechend Schritt e ermittelten Werten für jedes Pixel oder für ausgewählte Pixel die Abweichung des Pixelortes der Pixel von der Sollposition bestimmt wird.

2.  Verfahren nach Anspruch 1, wobei die Verschiebung zwischen Objekt und Messsystem im wesentlichen in Richtung der Flächennormale des Objektes erfolgt.

3.  Verfahren nach einem der vorhergehenden Ansprüche, wobei die Abweichung des Pixelortes der Pixel von der Sollposition ermittelt wird, indem jeweils für das betreffende Pixel der Fehler des Pixelortes durch Mittelwertbildung aller entsprechend Schritt e) des Anspruchs 1 ermittelten und für das betreffende Pixel relevanten Werte bestimmt wird.

4.  Verfahren nach Anspruch 1 oder 2, wobei die Abweichung des Pixelortes der Pixel von der Sollposition ermittelt wird, indem jeweils für das betreffende Pixel der Fehler des Pixelortes mittels Approximation aller entsprechend Schritt e) des Anspruchs 1 ermittelten Werte durch einer Funktion bestimmt wird.

**5.** Verfahren nach einem der vorhergehenden Ansprüche, wobei
die Bildaufnahmematrix ein CCD-Sensor oder ein CMOS-Sensor ist.

**6.** Verfahren nach einem der vorhergehenden Ansprüche, wobei
die Sollposition durch eine Kalibrierung des Messsystems bestimmt wird.

## Claims

**1.** Procedure for determining the deviation of the pixel location of the pixel of at least one imaging matrix from the target position, whereby the imaging matrix is a component of an optical 3D measuring system at least during the course of the procedure, whereby

a) an object that is suitable for measuring using the optical 3D measuring system is provided, whereby this object is plane or displays such a curvature that in step c corresponding to the smoothing only the local faults of the 3D data are averaged out and the contours of the object are not changed,
b) the object is measured through the 3D measuring system and 3D data of the object are ascertained in the course of this,
c) the 3D data ascertained for the object are then smoothed,
d) the 3D measuring points of the object are projected back onto the sensors of the at least one matrix camera using their 3D data both ascertained in accordance with step b and smoothed in accordance with step c,
e) the difference between the position of the two points allocated to a 3D measuring point that are projected back onto the sensors is ascertained,
f) after this a displacement between the object and the optical 3D measuring system is optionally effected or omitted,
g) steps b to f are repeated until the desired precision of the deviations in the pixel location of the pixels of an imaging matrix to be determined by the procedure has been achieved, whereby the precision depends on the number of repetitions and the number of displacements in accordance with step f,
h) and the deviation of the pixel location of the pixels from the target position is determined from the values ascertained in accordance with step e for each pixel or for selected pixels.

**2.** Procedure in accordance with claim 1, whereby the displacement between object and measuring system takes place essentially in the direction of the surface normals of the object.

**3.** Procedure in accordance with one of the preceding claims, whereby
the deviation of the pixel location of the pixels from the target position is ascertained by determining the fault of the pixel location for the subject pixel in each respective case by forming average values of all values ascertained in accordance with step e) of claim 1 that are relevant for the subject pixel.

**4.** Procedure in accordance with claim 1 or 2, whereby the deviation of the pixel location of the pixels from the target position is ascertained by determining the fault of the pixel location for the subject pixel through approximating all the values ascertained in accordance with step e) of claim 1 through a function.

**5.** Procedure in accordance with one of the preceding claims, whereby
the imaging matrix is a CCD sensor or a CMOS sensor.

**6.** Procedure in accordance with one of the preceding claims, in which
the target position is determined by a calibration of the measuring system.

## Revendications

**1.** Procédé permettant de déterminer l'écart de l'emplacement des pixels au moins d'une matrice de prise de vue par rapport à la position prescrite, moyennant quoi la matrice de prise de vue fait partie d'un système de mesure 3D optique au moins pendant le déroulement du procédé,

a) un objet approprié pour le jaugeage au moyen du système de mesure 3D optique étant fourni, cet objet étant plan ou présentant une courbure de telle manière à ce que, lors de l'étape c correspondant au lissage, seulement les erreurs locales des données 3D soient établies, mais que les contours de l'objet ne soient pas modifiés,
b) l'objet étant jaugé par le système de mesure 3D et les données 3D de l'objet étant établies,
c) puis les données 3D établies de l'objet étant lissées,
d) les points de mesure 3D de l'objet étant rétroprojetés sur les capteurs d'au moins une caméra matricielle à l'aide de leurs données 3D établies selon l'étape b ainsi que lissées selon l'étape c,

e) la différence entre la position des deux points rétroprojetés sur les capteurs et affectés à un point de mesure 3D étant déterminée,

f) ensuite, un décalage entre l'objet et le système de mesure 3D optique étant, au choix, effectué ou non,

g) les étapes b à f étant répétées jusqu'à ce que la précision souhaitée des écarts de l'emplacement des pixels d'une matrice de prise de vue, à définir au moyen du procédé, soit obtenue, la précision dépendant du nombre de répétitions et du nombre de décalages conformément à l'étape f,

h) et l'écart de l'emplacement des pixels par rapport à la position prescrite étant défini à partir des valeurs établies conformément à l'étape e pour chaque pixel ou pour des pixels sélectionnés.

2. Procédé conformément à la revendication 1, le décalage entre l'objet et le système de mesure s'opérant essentiellement dans le sens de la normale de surface de l'objet.

3. Procédé conformément à l'une des revendications précédentes, l'écart de l'emplacement des pixels par rapport à la position prescrite étant déterminé en définissant l'erreur d'emplacement du pixel, pour le pixel concerné, par l'établissement de la valeur moyenne de toutes les valeurs applicables, déterminées conformément à l'étape e) de la revendication 1 et pour le pixel concerné.

4. Procédé conformément à la revendication 1 ou 2, l'écart de l'emplacement des pixels par rapport à la position prescrite étant déterminé en définissant l'erreur d'emplacement du pixel, pour le pixel concerné, au moyen d'une approximation de toutes les valeurs déterminées conformément à l'étape e) de la revendication 1 par une fonction.

5. Procédé conformément à l'une des revendications précédentes, la matrice de prise de vue étant un capteur CCD ou un capteur CMOS.

6. Procédé conformément à l'une des revendications précédentes, la position prescrite étant définie par un étalonnage du système de mesure.

**Fig. 1**

**Fig. 2**

Kamera 1

Kamera 2

Meßsystem

Verschiebung der
Ebene in z-Richtung
(Ebenennormale)

**Fig. 3**

```
┌─────────────────────────────────────────────────────┐        ┌──────────────────┐
│  ┌─────────────────────┐                             │◀───────│  Verschiebung    │
│  │   3D-Vermessung     │◀─────────────────┐          │        │  der z-Lage      │
│  └─────────────────────┘                  │          │        └──────────────────┘
│            │                              │          │
│            ▼                              │          │
│  ┌─────────────────────┐                  │          │
│  │ Glättung der Meßdaten│                 │          │
│  └─────────────────────┘                  │          │
│            │                              ▼          │
│            ▼                  ┌─────────────────────┐ │
│  ┌─────────────────────┐     │    Rückprojektion    │ │
│  │    Rückprojektion    │    │ (linke und rechte    │ │
│  │ (linke und rechte    │    │      Kamera)         │ │
│  │      Kamera)         │    └─────────────────────┘ │
│  └─────────────────────┘              │              │
│            │         ┌─────────────────────┐         │
│            └────────▶│   Differenzbildung   │◀────────┘
│                      │ (linke und rechte    │          n mal
│                      │      Kamera)         │
│                      └─────────────────────┘
└──────────────────────────────│──────────────────────┘
                               ▼
                   ┌─────────────────────┐
                   │ Mittelwertbildung für│
                   │     jedes Pixel      │
                   │ (linke und rechte    │
                   │      Kamera)         │
                   └─────────────────────┘
                               │
                               ▼
                   ┌─────────────────────┐
                   │ Fehler der Pixelorte │
                   │ (linke und rechte    │
                   │      Kamera)         │
                   └─────────────────────┘
```

**Fig. 4**

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 19623172 C1
- DE 19727281

- DE 19623172